# EUROPEAN PATENT APPLICATION

(11) **EP 4 826 409 A1**
(43) Date of publication of application: **21.10.2026**
(21) Application number: 25170609.9
(22) Date of filing: 15.04.2025
(51) Int. Cl.: G01R 33/56, G01R 33/565

(54) **SYSTEM AND METHOD FOR REDUCING METAL-INDUCED IMAGING ARTIFACTS IN MRI**

(71) Applicant: Siemens Healthineers AG, 91301 Forchheim (DE); Universität Zürich, 8006 Zürich (CH)
(72) Inventor: Deck, Jeanette, 8152 Glattbrugg (CH); Hilbert, Tom, 1006 Lausanne (CH); Sutter, Reto, 8032 Zürich (CH); von Deuster, Constantin, Zürich 8057 (CH)
(74) Representative: Fischer, Michael

(57) **Abstract**

The invention relates to a system (200) and a method (300) for reducing metal-induced imaging artifacts in MRI, said method (300) comprising:
- acquiring (301) an MRI image of a biological object comprising a metal part, said MRI image representing said biological object in an image domain;
- identifying or defining (302), within said MRI image, a Region of Interest (ROI) comprising a metal-induced artifact resulting from said metal part;
- applying (303), at least to said ROI, a wave-like transformation from the image domain into a wave-like domain, wherein said wave-like transformation is configured for breaking down spatial information comprised in said ROI into oscillations characterized by oscillation components, and resulting in at least one transformed image encoding information about the metal-induced artifact;
- filtering (304) each transformed image encoding said information about the metal-induced artifact, wherein said filtering is configured for removing metal-induced artifact information from the concerned transformed image, resulting in a filtered transformed image;
- applying (305), to the filtered transformed image, an inverse wave-like transformation from the wave-like domain into the image domain, resulting into a filtered image;
- outputting (306) the filtered image.

## Description

### Technical Field

The present invention falls within the field of Magnetic Resonance Imaging (MRI) and proposes a system and a method for reducing metal-induced imaging artifacts in MRI.

### Background Art

A known issue within MRI concerns biological objects comprising a metal part, e.g. a metal implant. Indeed, the metal comprised in said part of the biological object can cause significant distortions in the magnetic field used in MRI, resulting in image artefacts. In particular, the appearance of metal-induced imaging artifacts in MRI can be complex, depending on the employed imaging sequence as well as type, material composition and orientation of the implant in the main magnetic field. State-of-the-art Turbo-Spin-Echo images show signal pileups and signal voids as well as geometric image distortions. Dedicated metal artifact reduction sequences like Slice Encoding for Metal Artifact Correction [1] (SEMAC) and Multi-Acquisition with Variable-Resonance Image Combination [2,3] (MAVRIC) employ multiple frequency spectra to cover the metal-induced broadened frequency range. Hence, SEMAC and MAVRIC are commonly referred as multi-spectral-imaging (MSI) sequences and used to reduce imaging artifacts due to relatively large metal hardware, e.g. total hip or knee arthroplasty. However, a significant drawback of these techniques are additional signal ripples in the vicinity of the implant. These distinct artifacts occur in case of concurrent in- and through-plane magnetic field variations, but are also a result of sub-optimal combination of spectral profiles during the reconstruction process. In general, MSI ripple artifacts render the diagnosis of the affected area very challenging, which is particularly unfavourable as fluid collection or tissue inflammation are commonly seen in close proximity to the implant.

It is therefore desired to find a solution for reducing or removing such MSI ripple artifacts.

### Summary of Invention

An objective of the present invention is to propose a method and a system capable of reducing metal-induced imaging artifacts in MRI that are easy to implement, and free of any penalty regarding the MRI scan time or Specific Absorption Rate (SAR), so that the comfort and safety of a patient undergoing an MRI scan be not compromised.

This objective is achieved by the measures taken in accordance with the independent claims. Further advantageous embodiments are proposed by the dependent claims.

More precisely, the present invention concerns a method, preferentially a computer-implemented method, for reducing metal-induced imaging artifacts in MRI, said method comprising:
a) acquiring an MRI image of a biological object comprising a metal part (i.e. a part made of, or comprising, a metal component capable of creating a distortion in the magnetic field used during MRI), said MRI image representing said biological object in an image domain;
b) identifying, within the acquired MRI image, a Region of Interest (ROI) comprising a metal-induced artifact resulting from said metal part (e.g. by identifying ripple artefacts in the MRI image);
c) applying, at least to said ROI, preferentially to the MRI image, a wave-like transformation from the image domain into a wave-like domain, wherein said wave-like transformation is configured for breaking down spatial information comprised in said ROI (or in said MRI image if applied to the whole MRI image) into oscillations characterized by oscillation (or wave-like) components (i.e. decomposing the spatial information of the ROI/MRI image into a combination of wave-like signals), and resulting in at least one transformed image (in the wave-like domain associated to the wave-like transformation) encoding or comprising information about the metal-induced artifact. In the following, the transformed image will be used to refer to both the result of applying the wave-like transformation to the ROI and the result of applying the wave-like transformation to the MRI image, the concept being the same for both cases;
d) filtering each transformed image encoding or comprising said information about the metal-induced artifact, wherein said filtering is configured for removing metal-induced artifact information from the concerned transformed image, resulting in a filtered transformed image (in the wave-like domain);
e) applying, to each filtered transformed image, an inverse wave-like transformation from the wave-like domain into the image domain, in order to obtain, for said acquired MRI image, a filtered image with reduced metal-induced artifact;
f) outputting the filtered image.

The present invention concerns also a system for reducing metal-induced imaging artifacts in MRI, the system comprising:
- a first interface for acquiring an MRI image of a biological object comprising a metal part;
- a processing unit comprising a processor and a memory, said processing unit being configured for processing said MRI image;
wherein said processing unit is configured for carrying out the steps of the previously described method.

### Description of Embodiments

The present invention proposes to process in a wave-like domain images which have been acquired by an MRI apparatus and which comprise metal-induced artifacts. Preferentially, a SEMAC or MAVRIC MRI sequence is used for acquiring the MRI image. Processing the acquired image, or at least the ROI, in the wave-like domain requires to transform the signal intensities of the acquired MRI image which are originally in an image domain into new signal intensities representing the same image (i.e. the same information) in the wave-like domain. According to the present invention, by "ROI", one refers to the part of the acquired MRI image that comprises the metal-induced artifacts - it is thus a subsample of the acquired MRI image. The processing of said MRI images in the wave-like domain enables an improved filtering out of said metal-induced artifacts.

According to a preferred embodiment, the wave-like transformation used for transforming at least said ROI from the image domain into the wave-like domain is a Fourier transform (FT). Accordingly, the inverse wave-like transformation is in this case an inverse FT and said oscillations that encode, in the wave-like domain, the spatial information of the ROI are sine waves. The oscillation components are in this case frequencies characterizing said sine waves, enabling to capture frequency information from said spatial information and to represent said ROI in a frequency domain of the FT. According to this preferred embodiment, the FT converts thus the spatial information of the acquired MRI image into sinusoidal components of different frequencies. Preferentially, said filtering uses then a Fourier Domain Filter, hereafter FD-Filter, comprising a Gaussian ring mask characterized by a radius *r* and a width *w*. In particular, said radius *r* and said width w are automatically determined by the system according to the invention from a radial spectral energy density (RSED) distribution peak [4]. For instance, frequency components related to metal-induced artifacts might be automatically identified in said RSED distribution, and a value for the radius *r* and a value for the width *w* that enable to filter out the identified frequency components might be automatically assigned to *r* and *w* respectively. Typically, the system according to the invention might be configured for automatically finding, within said RSED distribution, e.g. within a predefined interval for k-space values within said RSED distribution, a local maximum that will be assigned to the artifact, i.e. that correspond to said artifact. For instance, said predefined interval comprises k-space radius values comprised between 0.2-2 cm⁻¹ , and the system might automatically identify, within said predefined interval, a local maximum that needs to be filtered out by said Gaussian ring mask. Preferably, said RSED distribution is configured for neglecting low frequency components, given that the latter correspond to image information and not to artifact information.

According to another preferred embodiment, the wave-like transformation used for transforming at least said ROI from the image domain into the wave-like domain is a wavelet transform (WT), for instance a continuous WT, also called CWT, or a discrete WT, also called DWT. According to this another preferred embodiment, the inverse wave-like transformation is an inverse WT, said oscillations are wavelets, and the oscillation components are approximation coefficients (or approximation planes) and detail coefficients, which enable to capture frequency (i.e. scale) and location (i.e. the position of the wavelet in time or space) information from said spatial information and to represent said ROI in a wavelet domain. The WT is thus configured for converting spatial information comprised within the ROI of the MRI image into said approximation and detail coefficients. Preferably, said filtering is a threshold-based filtering configured for filtering out detail coefficients with respect to at least one filtering threshold or filtering parameter which might be stored in, or calculated by, the system according to the invention, or defined by a user. Typically, said filtering threshold(s) or parameter(s) is (are) used by the system according to the invention for automatically defining a filtering interval, for instance centred around the filtering threshold or parameter, and detail coefficients with values outside said filtering interval, e.g. with values above the highest value of the filtering interval and below the lowest value of the filtering interval, are filtered out (i.e. the value of the detail coefficient is set to 0). The size of said filtering interval might be automatically determined by the system from a gap which might be predefined, or automatically calculated by the system according to the invention. For instance, the filtering threshold (or parameter) might be used for cutting off (i.e. for setting to zero) extreme values of the detail coefficient in the ROI: typically, detail coefficient (absolute) values greater than said filtering threshold (or parameter) are considered extreme and set to zero. The filtering threshold itself might be set as being equal to the maximum (absolute) value of the detail coefficients multiplied by a weighting factor *f* whose value is typically comprised between 0 and 1: 0 < *f* < 1. The value of the weighting factor *f* might be predefined in a memory of the system according to the invention, set by a user, or computed automatically from a distribution of the (absolute) values of the detail coefficients. Alternatively, an upper filtering interval value might be defined as tₜₕ + *f*' · σ and a lower filtering interval value might be defined as tₜₕ - *f*' · σ, wherein tₜₕ is said filtering parameter, σ is the gap, and the filtering interval is defined as [tₜₕ - *f'* · σ ; tₜₕ + *f*' · σ] , wherein *f*', as *f*, is a weighting factor whose value is typically comprised between 0 and MAX (0 < *f*' < MAX, wherein MAX is determined by (in function of) the maximum absolute value taken by the detailed coefficients), and might be predefined in the memory of the system according to the invention, set by a user, or computed automatically from a distribution of the (absolute) values of the detail coefficients. Preferentially, tₜₕ and σ are automatically determined by the system by calculating tₜₕ as the mean of the detail coefficient values and σ as the standard deviation of the detail coefficient values. For instance, tₜₕ and σ might be obtained by fitting, with a Gaussian function, a plot histogram of the detail coefficient values, and assigning to tₜₕ the mean detail coefficient value resulting from said fitting, and to σ the standard deviation obtained from said fitting. At the end, the filtering interval is then preferentially defined as [tₜₕ - *f'* · σ ; tₜₕ + *f'* · σ] and detail coefficient values outside from said filtering interval are set to zero.

Preferentially, said detail coefficients are separated into three directions, namely a horizontal, vertical, and diagonal direction, separating therefore the detail coefficients into horizontal, vertical, and diagonal coefficients. The previously mentioned threshold-based filtering might be applied then to each of said direction, the system calculating for instance for each of said direction a respective filtering threshold and gap in order to determine a respective filtering interval. Preferentially, the method according to the invention further comprises applying a high-pass filter to each of said directions before applying said filtering to the transformed image, notably before applying the threshold-based filtering.

Preferentially, the wavelet according to the invention belongs to one of the following wavelet families: a Fejér-Korovkin wavelet family, or a Daubechies wavelet family, or a Beylkin wavelet family.

Preferentially, the system according to the invention, notably its processing unit, is configured for using a first neural network for automatically identifying said ROI, wherein said first neural network has been trained on a first input training dataset and a first output training dataset, wherein said first input training dataset comprises MRI images of training biological objects comprising each a metal part, and the first output training dataset comprises, for and associated to each of said MRI images of the input training dataset, a corresponding ROI defined for said MRI image and comprising metal-induced artifacts.

Preferentially, the system according to the invention, notably its processing unit, is configured for using a second neural network for automatically performing the wave-like transformation, wherein said second neural network has been trained on a second input training dataset and a second output training dataset, wherein the second input training dataset comprises a training set of MRI images in the image domain comprising notably images of biological objects comprising a metal part, and the second output training dataset comprises, for and associated to each of said MRI images of the training set, a corresponding image in the wave-like domain, which typically has been obtained by applying said wave-like transformation to said MRI image of the training dataset.

Preferentially, the system according to the invention, notably its processing unit, is configured for using a third neural network for automatically performing said filtering of the or each transformed image encoding metal-induced artifact information, wherein said third neural network has been trained on a third input training dataset and a third output training dataset, wherein the third input training dataset comprises a training set of transformed images, each obtained by applying said wave-like transformation to a source image of a biological object comprising a metal part and each encoding metal-induced artifact information, and the third output training dataset comprises, for and associated to each of said transformed images of the training set, a corresponding filtered transformed image.

Preferentially, the system according to the invention, notably its processing unit, is configured for training a fourth neural network for automatically reducing metal-induced imaging artifacts in MRI images, wherein said fourth neural network is trained on a fourth input training dataset and a fourth output training dataset, wherein the fourth input training dataset comprises acquired MRI images of one or several biological objects comprising each a metal part and the fourth output training dataset comprises, for each of said MRI images of the fourth input training dataset, a corresponding filtered image obtained by performing the steps a)-f) of the previously described method. For instance, the fourth input training dataset may comprise said acquired MRI image of the biological object comprising said metal part and several other of such MRI images of other biological objects comprising respectively a metal part, and the fourth output training dataset may comprise said outputted image and, for each of said several other MRI images of said other biological objects, a corresponding filtered image obtained by performing the steps a)-f) of the claimed method.

### Brief Description of the Drawing

Further aspects of the present invention will be better understood through the following drawings, wherein like numbers designate like objects:
- Fig. 1: SEMAC ripple artifacts (hollow arrow, and solid arrow) in CoCr total knee joint replacement (A) and Titanium total hip arthroplasty (B);
- Fig. 2: schematic illustration of a preferred embodiment of a system according to the invention;
- Fig. 3: flowchart of a preferred embodiment of a method according to the invention;
- Fig. 4: example of a selection of a ROI containing ripple artifacts;
- Fig. 5: example of a transformed image obtained by applying a WT to the image of Fig. 4;
- Fig. 6: example of a filtered transformed image obtained by applying a filtering to the transformed image of Fig. 5;
- Fig. 7: example of a filtered image obtained by applying an inverse WT to the filtered transformed image of Fig. 6;
- Fig. 8: another example of a selection of a ROI containing ripple artifacts;
- Fig. 9: example of transformed image obtained after applying a FT to the ROI of Fig. 8;
- Fig. 10: RSED distribution of the transformed image obtained in Fig. 9, and determination of a corresponding Gaussian ring mask;
- Fig. 11: example of a filtered transformed image obtained by applying the Gaussian ring mask of Fig. 10 to the transformed image of Fig. 9;
- Fig. 12: example of a filtered image obtained by applying an inverse FT to the filtered transformed image of Fig. 10.

### Description of Examples

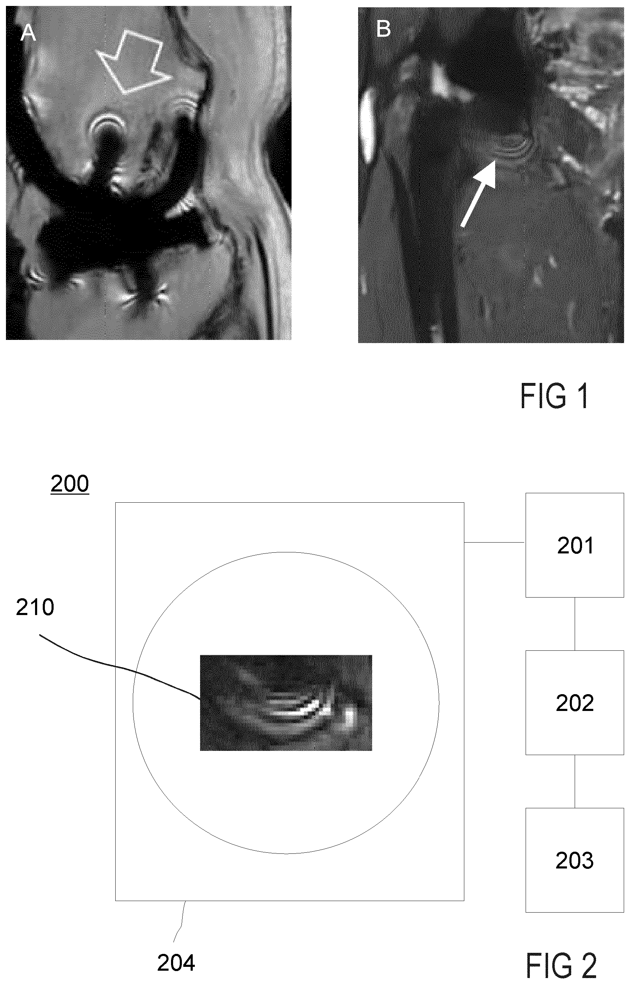

Figure 1 illustrates the problematic at the origin of the present invention, i.e. metal-induced imaging artifacts in MRI. SEMAC ripple artifacts in CoCr total knee joint replacement can be observed in image A (see the arrow), which has been taken from the paper of Otazo et al. [4]. Image B shows then SEMAC ripple artifacts (see the arrow) in Titanium total hip arthroplasty. As it can be seen from image A and B, the ripples appearing around parts of the respective metal implant prevent a clear view of tissue that is at close proximity of said metal implant parts, challenging or even preventing an adequate interpretation of the image. The present invention enables to reduce or remove such ripples appearing in MRI in the presence of metallic parts in a biological object.

Figure 2 illustrates very schematically a preferred embodiment of a system 200 according to the invention. Said system 200 comprises a first interface 201 for acquiring or receiving an MRI image of a biological object 210. Said biological object 210 is for instance a patient or part of a patient, like a pelvis region or a knee region. Said MRI image of the biological object 210 might have been acquired by means of an MRI apparatus 204, which might be part or not of the system 200 according to the invention. Said system 200 further comprises a processing unit 202 in charge of processing the MRI image of the biological object 210. Said processing unit 202 typically comprises one or several processors and a storage device like a memory. The system 200 according to the invention may further comprise a second interface 203 for outputting a filtered image of the received or acquired MRI image and/or a display for displaying said filtered image.

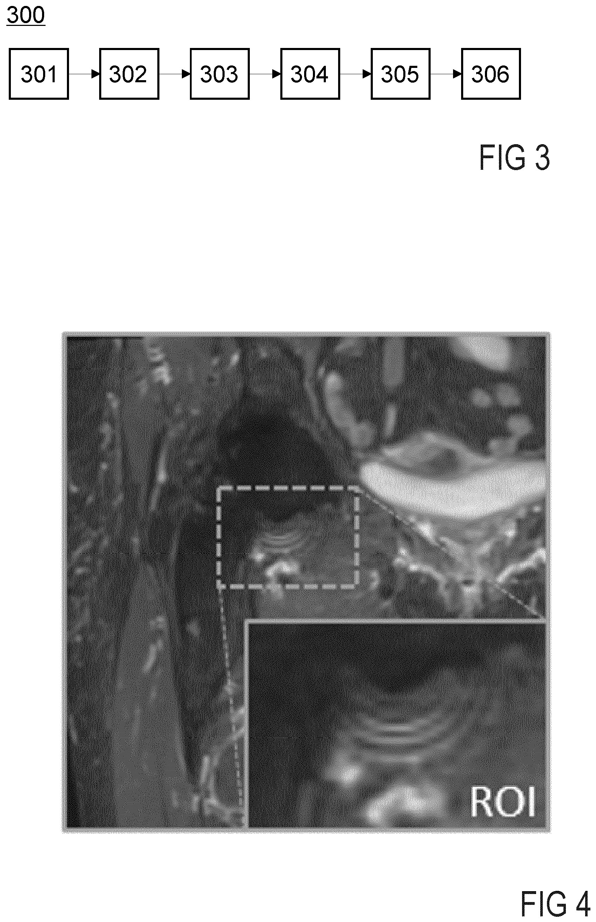

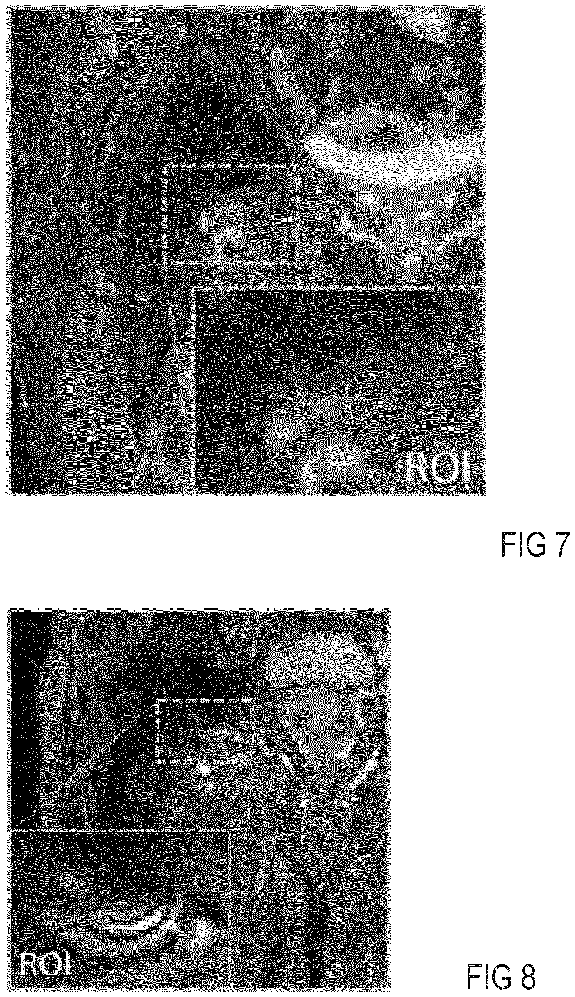

In connection with Figure 3, the principles of the present invention for reducing metal-induced imaging artifacts in MRI will be described in more detail hereafter in connection with the method 300. In particular, two preferred embodiments of the claimed methods will be explained in more detail. A first preferred embodiment based on a filtering realized in a WT domain is illustrated by the Figures 4 to 7, and a second preferred embodiment based on a filtering realized in a FT domain is illustrated by the Figures 8 to 12.

At step 301, the system 200 according to the invention acquires or receives an MRI image of a biological object 210. Said MRI image is typically a 2D image. Said biological object 210 comprises, at some location, a metal component or part that may interfere with the magnetic field used during MRI data acquisition. An example of such MRI image is shown with Figure 4, wherein ripples appear at close proximity of a hip implant. Another example is provided by Figure 8, also for a hip implant. Each of the acquired MRI images are represented in the image domain, wherein spatial information is represented or encoded by the different pixel intensities of the image.

At step 302, the system 200, preferentially its processing unit 202, identifies or defines, within said MRI image, a ROI comprising metal-induced artifacts resulting from said metal part. In both Figures 4 and 8, said ROI corresponds to the enlarged part shown at the bottom of the image. The ROI is, as known in the art, a part of the acquired MRI image that comprises the metal-induced artifact. Said ROI could be also the whole MRI image. To identify or define said ROI, the processing unit 202 might automatically use a ripple recognition algorithm that is configured for searching, within the acquired image, signal intensities that manifest themselves as wave-like patterns, said ripple recognition algorithm being further configured for automatically identifying or defining a ROI as an area that comprises the found ripples. Indeed, such wave-like patterns typically correspond to metal-induced artifacts. Said ripple recognition algorithm might be a machine learning algorithm, for instance a first neural network, that has been specifically trained for identifying or detecting ripples in the acquired MRI image and automatically defining and/or selecting a ROI comprising the identified ripples. Other techniques for identifying or detecting ripples in the acquired image might be contemplated, like feature-based image recognition, wherein the ROI is then identified or defined as a subpart or subarea within the acquired MRI image and that comprises the identified or detected ripples.

At step 303, the system 200, preferentially its processing unit 202 is configured for applying to at least the ROI a wave-like transformation. The latter is configured for converting an image received as input and belonging to the image domain into at least one transformed image that belongs to the wave-like domain and which is provided as output. In particular, said wave-like transformation might be applied to the acquired MRI image (i.e. to the whole image) or only to the ROI. The "transformed image" refers hereafter to both cases, i.e. to an image that would have been obtained after applying the wave-like transformation to the ROI only as well to an image that would have been obtained after applying the wave-like transformation to the whole image. In other words, no distinction will be made between these two cases given that the concept of the invention applies mutatis mutandis to both of them. The wave-like transformation is configured for converting the spatial information (i.e. pixel location and its intensity) of the whole image or ROI (i.e. of the part of the image that comprises the metal-induced artifact), into a combination of wave-like signals (i.e. oscillations) configured for encoding said spatial information into oscillations components of the wave-like signals, transforming therefore the ROI originally represented in the image domain into one or several transformed images (depending on the wave-like transformation that is used by the system), wherein each of the transformed image is represented in the wave-like domain associated to the wave-like transformation, and wherein at least one of said transformed image will encode information about the metal-induced artifact that was present in the image used as input.

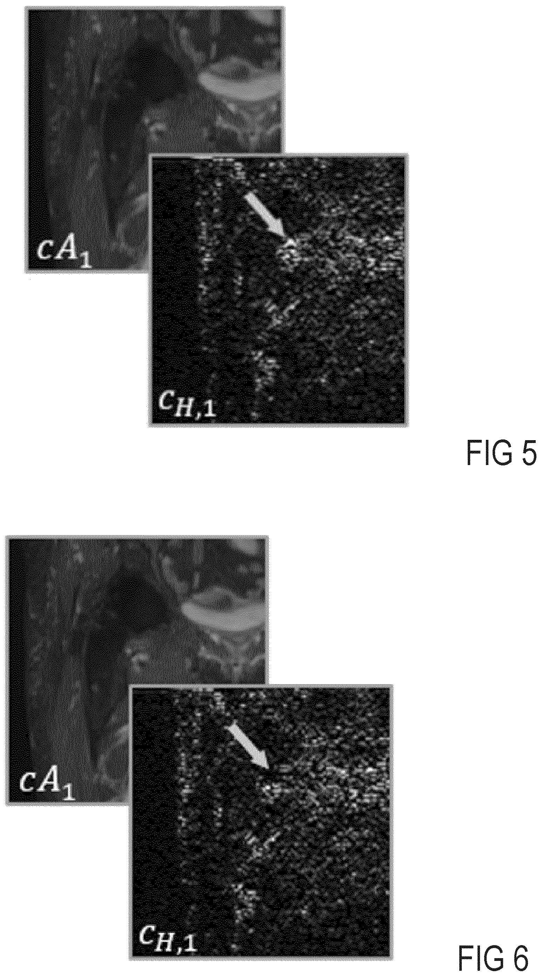

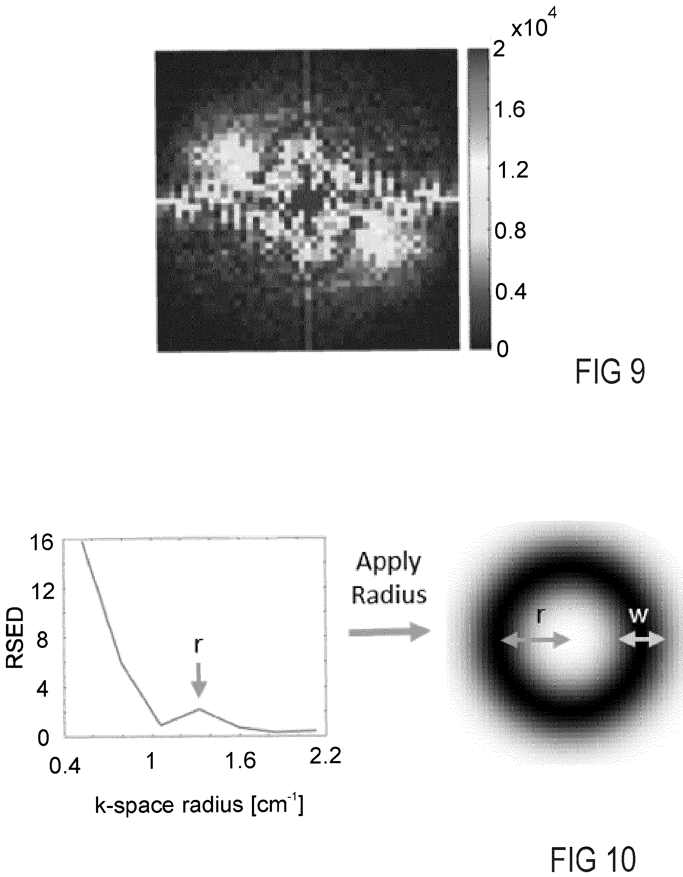

Two examples of transformed images obtained after applying the wave-like transformation according to the invention are illustrated by the Figures 5 and respectively 9, wherein a wavelet transform (or transformation) is used for achieving said wave-like transformation in Fig. 5, and respectively a Fourier transform (or transformation) is used for achieving said wave-like transformation in Fig. 9.

The wavelet transformation decomposes an image, e.g. the ROI, into different spatial frequency bands, resulting in oscillation components that are called "approximation coefficients" and "detail coefficients" which are each associated to a transformed image (i.e. a transformed image is generated for each of said coefficient). The approximation coefficients capture the low frequencies, thus representing the main structures with slowly varying intensities of the image. In contrast, the detail coefficients represent higher frequencies and finer image details, and their respectively associated transformed image encodes thus the information about the metal-induced artifact. Said detail coefficients are typically separated into horizontal, vertical, and diagonal components or directions. When applying the WT to the ROI (or whole image), the system will automatically create, at least for each of the detail coefficients, a transformed image that comprises information related to the metal-induced artifact. Typically, planes, edges, transitions, and alterations exhibit high absolute (intensity) values in the transformed images associated to the detail coefficients, while homogeneous areas show low absolute values. Preferentially, the system according to the invention may store, e.g. in a memory or database, one or several wavelet families that can be used by its processing unit for performing the WT. The wavelet family used for a WT might be selected by a user, or might be predefined in function of material and/or geometrical properties of the metal part, wherein said material and/or geometrical properties might be received as input by the system according to the invention for enabling an automatic selection of said wavelet family. For each wavelet family, the system may store one or several parameters that are then automatically used by the processing unit for performing said WT. Said parameters are for instance a number Nᵥ of vanishing moments, and a number N_{L} of decomposition levels. Preferentially, said number of vanishing moments is comprised between 6 and 12: 6 ≤ Nᵥ ≤ 12. Preferentially, said number of decomposition levels is comprised between 1 to 3: 1 ≤ N_{L} ≤ 3.

An example of a wavelet transform according to the invention is the discrete wavelet transform (DWT). The latter uses filter banks, i.e. a set of band pass filters, to decompose an input signal, here the ROI, i.e. a 2D image, into the so-called approximation and detailed coefficients. Typically, the DWT comprises:
- a mother wavelet *ψ*(*t*): $ψ \left(t\right) = {\sum }_{n} {h}_{1} \left(n\right) ⋅ \sqrt{2} ⋅ ϕ \left(2t-n\right)$
- a scaling function *ϕ*(*t*) also called "father wavelet": $ϕ \left(t\right) = {\sum }_{n} {h}_{0} \left(n\right) ⋅ ϕ \left(2t-n\right)$ wherein
   t is a spatial variable;
   h₀ is a half-band low-pass filter and h₁ is a high-pass filter, which are determined by the selected wavelet (i.e. wavelet types or families are each associated to a corresponding h₀ filter and a corresponding h₁ filter which are defined for the considered wavelet type/family, and which are then used in the above-mentioned equations);
   n is an integer index used for shifting and scaling the wavelet transform;
   wherein the approximation coefficients are given by: ${LL}^{j} \left(x, y\right) = {\sum }_{m} {\sum }_{n} {h}_{0} \left(m-2x\right) {h}_{0} \left(n-2y\right) ⋅ {LL}^{j + 1} \left(m, n\right)$
   and the detail coefficients are given by:
   *HL^{j}*(*x*,*y*) = ∑*ₘ*∑*ₙh*₀(*m* - 2*x*)*h*₁(*n* - 2*y*) *· LL*^{*j*+1}(*m,n*) (horizontal detail coefficient)
   *LH^{j}*(*x,y*) = ∑*ₘ*∑*ₙh*₁(*m* - 2*x*)*h*₀(*n* - 2*y*) *· LL*^{*j*+1}(*m*,*n*) (vertical detail coefficient)
   *HH^{j}*(*x,y*) = ∑*ₘ*∑*ₙh*₁(*m* - 2x)*h*₁(*n* - 2*y*) *· LL*^{*j*+1}(*m,n*) (diagonal detail coefficient) with, due to orthogonality, ${h}_{1} \left(n\right) = {\left(-1\right)}^{n} {h}_{0} \left(1-n\right)$
   wherein
   "L" and "H" stands for low- and high pass filtering, respectively. The first letter denotes the operation performed on the columns of the 2D image matrix (i.e. the input signal (e.g. a 2D image) is represented as a 2D array or matrix of pixels (which represents said 2D image) and which comprises columns and rows), and the second letter indicates the operation on the rows of said 2D image matrix. Thanks to the high pass filter, the detail coefficient is able to represent higher frequencies and finer image details, and this for each direction;
   (m,n) are integer indices that represent the pixel coordinates in the 2D image matrix;
   (x,y) are integer indices representing the pixel coordinates upon twofold subsampling and filter application, i.e. lower spatial resolution;
   j is an index used for labeling the level of decomposition and represents a scale of spatial resolution, i.e. j+1 represents the next finer scale, i.e. higher spatial resolution. In above equations, the index j is reduced by one for each decomposition step. The decomposition of the ROI into wavelets can be applied iteratively to the LL component for additional decomposition levels of detail analysis, wherein j+1 represents a lower decomposition level (with higher spatial resolution), and j-1 a higher decomposition level (with lower spatial resolution), wherein each next decomposition level needs the result of the previous decomposition level.

In this context, Fig. 5 illustrates approximation coefficients (image cA₁) obtained for a first level (i.e. j=1) wavelet transformation (decomposition) of the whole image appearing in Figure 4, and corresponding horizontal detail coefficients (image C_{H,1}) obtained for said first level decomposition. The arrow in the image C_{H,1} points to a higher intensity region, wherein the values of the horizontal detail coefficients are associated to the metal-induced artifacts. As illustrated in Fig. 5, metal-induced artifact information encoded in the transformed image obtained for the detail coefficients (here horizontal) is clearly visible, while metal-induced artifact information encoded in the transformed image obtained for the approximation coefficient is not visible (i.e. it cannot be easily distinguished from other encoded information that is useful for imaging the biological object. Figure 9 shows another transformed image which is obtained when applying a FT to the image of Figure 8. In this case, a single transformed image is obtained per inputted MRI image.

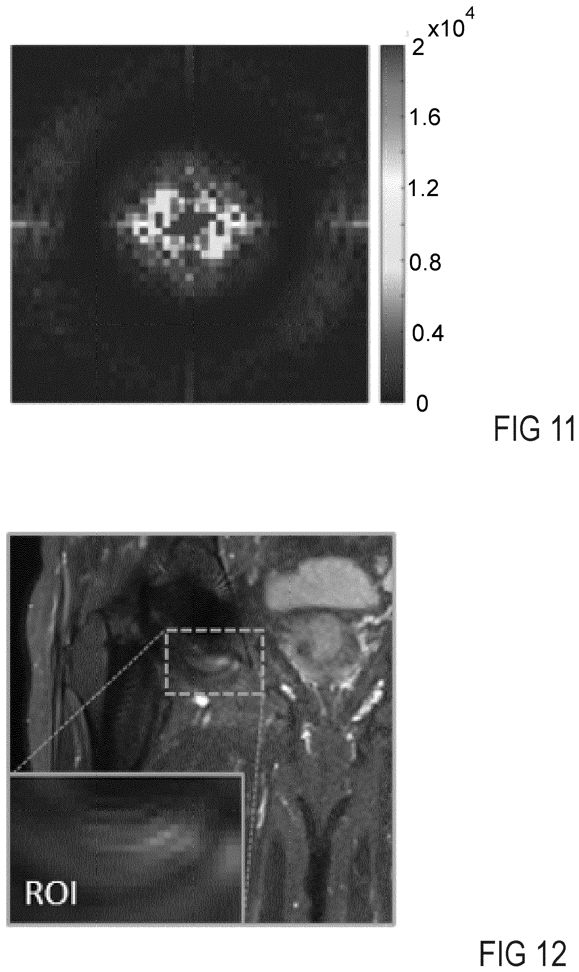

At step 304, the system 200, preferentially its processing unit 202 is configured for applying a filter to each transformed image that encodes said metal-induced artifact, wherein said filter is configured for removing from said transformed image said metal-induced artifacts, i.e. said information related to the metal-induced artifact, resulting in a filtered transformed image that is free, or at least comprises a reduced information related to the metal-induced artifact. Examples of such filtered transformed images obtained after the claimed filtering are illustrated by Fig. 6 for the WT and Fig. 11 for the FT. In Fig. 6, image C_{H,1} is the filtered transformed image obtained after applying the filtering according to the invention to the image C_{H,1} of Fig. 5. One can see, at the tip of the arrow, that the high intensity values of the detail coefficients that were associated to the metal-induced artifact have been removed. Preferentially, in order to obtain such a result, a threshold-based filter has been applied to the image C_{H,1} of Fig. 5. In particular, for each transformed image associated to a detail coefficient, a corresponding threshold-based filter might be applied for removing from the transformed image information related to the metal-induced artifact. In the case of the FT, the filtered transformed image illustrated by Fig. 11 has been obtained after applying a Gaussian ring mask to the transformed image shown in Fig. 9. Said Gaussian ring mask filtering is illustrated in Fig. 10. It is typically characterized by a radius *r* and a width *w* which might be automatically determined by the system, notably by said processing unit, from the RSED distribution in function of the k-space radius obtained for the transformed image which is illustrated in Fig. 9. Said RSED distribution typically shows a distinct peak that characterizes the metal-induced artifact. Preferentially, for said RSED distribution, low frequency components are automatically ignored by the system according to the invention for the determination of said Gaussian ring mask. Indeed, said low frequency components correspond to image information (notably high MRI signals (known as "DC"-peak) in the k-space center), and not to metal-induced artifact information. In particular, the processing unit is capable of automatically identifying, within said RSED distribution, the peak related to metal-induced artifact by determining for instance the maximum of said RSED distribution within a predefined interval of k-space values, wherein said predefined interval might be stored in a memory of the system according to the invention or provided by a user. Then the processing unit is configured for assigning to the radius *r* the k-space value corresponding to said maximum, while the width w might be obtained by fitting the RSED distribution peak comprising said maximum or empirically, notably from the width of said peak, and so that frequency components corresponding to said peak are then removed from the transformed image when applying the Gaussian ring mask, resulting thus in the so-called filtered transformed image as shown in Fig. 11.

At step 305, the system 200, preferentially its processing unit 202, is configured for applying, to each filtered transformed image, an inverse wave-like transformation from the wave-like domain into the image domain, in order to obtain, for the MRI image received as input, a filtered image in the image domain. The inverse wave-like transformation will use as input all filtered transformed images that have been generated as well as any transformed image that has not been filtered if any, and generated as output said filtered image. Figure 7 presents a filtered image obtained by applying the WT to the MRI image shown in Figure 4, followed by the threshold-based filtering previously described and illustrated by Figures 5 and 6, and an inverse WT applied to the filtered transformed images (one per detail coefficient) and the non-filtered transformed image (i.e. the transformed image associated to the approximation coefficient). Figure 12 presents a filtered image obtained by applying the FT transform to the MRI image shown in Figure 8, followed by the filtering illustrated by Figures 9 to 11, and an inverse FT applied to the filtered transformed image shown in Fig. 11.

At step 306, the system 200, preferentially its processing unit 202, is configured for outputting the filtered image, for instance via said second interface. The filtered image might be typically displayed on a screen, for instance together with the MRI image for comparison purposes.

To conclude, the present invention proposes a new way for reducing metal-induced imaging artifacts in MRI based on the post-processing of MRI images in a wave-like domain. The proposed solution advantageously does not affect the scan time or SAR value of an MRI scan, ensuring thus safety and comfort of the patient comprising a metal implant and undergoing said MRI scan, while improving the quality of the obtained MRI image by reducing or removing any metal-induced imaging artifacts.

### List of citations

[1] Lu W, Pauly KB, Gold GE, Pauly JM, Hargreaves BA. SEMAC: Slice encoding for metal artifact correction in MRI. Magn Reson Med. 2009;62(1):66-76. doi:10.1002/mrm.21967.
[2] Koch KM, Brau AC, Chen W, et al. Imaging near metal with a MAVRIC-SEMAC hybrid. Magn Reson Med. 2011;65(1):71-82. doi:10.1002/mrm.22523.
[3] Koch KM, King KF, Carl M, Hargreaves BA. Imaging near metal: The impact of extreme static local field gradients on frequency encoding processes. Magn. Reason. Med. 2014;71(6):2024-2034. doi:10.1002/mrm.24862.
[4] Jonas Wahlen, Sebastian Kozerke, Daniel Nanz, Reto Sutter and Constantin von Deuster, "Ripple Artifact Quantification in Slice Encoding for Metal Artifact Correction (SEMAC) using MR Bloch Simulation", ISMRM 2024.

## Claims

1. Method (300) for reducing metal-induced imaging artifacts in MRI, said method (300) comprising:
- acquiring (301) an MRI image of a biological object comprising a metal part, said MRI image representing said biological object in an image domain;
- identifying or defining (302), within said MRI image, a Region of Interest (ROI) comprising a metal-induced artifact resulting from said metal part;
- applying (303), at least to said ROI, a wave-like transformation from the image domain into a wave-like domain, wherein said wave-like transformation is configured for breaking down spatial information comprised in said ROI into oscillations **characterized by** oscillation components, and resulting in at least one transformed image encoding information about the metal-induced artifact;
- filtering (304) each transformed image encoding said information about the metal-induced artifact, wherein said filtering is configured for removing metal-induced artifact information from the concerned transformed image, resulting in a filtered transformed image;
- applying (305), to the filtered transformed image, an inverse wave-like transformation from the wave-like domain into the image domain, resulting into a filtered image;
- outputting (306) the filtered image.

2. Method (300) according to claim 1, wherein said wave-like transformation is a Fourier transform, hereafter FT, said inverse wave-like transformation is an inverse FT, said oscillations are sine waves, and said oscillation components are frequencies characterizing said sine waves, enabling to capture frequency information from said spatial information and to represent said ROI in a frequency domain of the FT.

3. Method (300) according to claim 2, wherein said filtering uses a Fourier Domain Filter, hereafter FD-Filter, comprising a Gaussian ring mask **characterized by** a radius *r* and a width w.

4. Method (300) according to claim 3, wherein said radius *r* and said width *w* are automatically determined from a radial spectral energy density, hereafter RSED, distribution peak, wherein frequency components related to metal-induced artifacts are automatically identified in said RSED distribution, and a value for the radius *r* and a value for the width w that enable to filter out the identified frequency components are automatically assigned to *r* and *w* respectively.

5. Method (300) according to claim 1, wherein said wave-like transformation is a wavelet transform, hereafter WT, said inverse wave-like transformation is an inverse WT, said oscillations are wavelets, and said oscillation components are approximation coefficients and detail coefficients, enabling to capture frequency and location information from said spatial information and to represent said ROI in a wavelet domain.

6. Method (300) according to claim 5, wherein said filtering is configured for filtering out detail coefficients with respect to a filtering threshold.

7. Method (300) according to claim 5 or 6, wherein said detail coefficients are separated into three directions, namely a horizontal, vertical, and diagonal direction, separating therefore the detail coefficients into horizontal, vertical, and diagonal coefficients, and wherein a threshold-based filtering is applied to each direction.

8. Method (300) according to claim 7, comprising applying a high-pass filter to each of said directions before applying said filtering to the transformed image.

9. Method (300) according to one of the claims 5 to 8, wherein said wavelet belongs to one of the following wavelet families: a Fejér-Korovkin wavelet family, or a Daubechies wavelet family, or a Beylkin wavelet family.

10. Method (300) according to one of the previous claims, wherein a SEMAC or MAVRIC MRI sequence is used for acquiring the MRI image.

11. Method (300) according to one of the claims 1 to 10, comprising using a first neural network for automatically identifying said ROI, wherein said first neural network has been trained on a first input training dataset and a first output training dataset, wherein said first input training dataset comprises MRI images of training biological objects comprising each a metal part, and the first output training dataset comprises, for and associated to each of said MRI images of the input training dataset, a corresponding ROI defined for said MRI image and comprising a metal-induced artifact.

12. Method (300) according to one of the claims 1 to 11, comprising using a second neural network for automatically performing the wave-like transformation, wherein said second neural network has been trained on a second input training dataset and a second output training dataset, wherein the second input training dataset comprises a training set of MRI images in the image domain, and the second output training dataset comprises, for and associated to each of said MRI images of the training set, a corresponding image in the wave-like domain.

13. Method (300) according to one of the claims 1 to 12, comprising using a third neural network for automatically performing said filtering of the transformed image encoding metal-induced artifact information, wherein said third neural network has been trained on a third input training dataset and a third output training dataset, wherein the third input training dataset comprises a training set of transformed images encoding metal-induced artifact information, each obtained by applying said wave-like transformation to a source image of a biological object comprising a metal part, and the third output training dataset comprises, for and associated to each of the transformed images of the training set, a corresponding filtered transformed image.

14. Method (300) according to one of the claims 1 to 13, comprising training a fourth neural network for automatically reducing metal-induced imaging artifacts in MRI images, wherein said fourth neural network is trained on a fourth input training dataset comprising acquired MRI images of a biological object comprising a metal part and, and on a fourth output training dataset comprising, for each of said MRI images of the fourth input training dataset, a corresponding filtered image obtained by performing the steps of claim 1.

15. System (200) for reducing metal-induced imaging artifacts in MRI, the system (200) comprising:
- a first interface (201) for acquiring an MRI image of a biological object (210) comprising a metal part;
- a processing unit (202) comprising a processor and a memory, said processing unit (202) being configured for processing said MRI image;
wherein said processing unit (202) is configured for carrying out the steps of the method according to one of the claims 1 to 14.
